# EUROPEAN PATENT APPLICATION

(11) **EP 4 618 063 A1**
(43) Date of publication of application: **17.09.2025**
(21) Application number: 23896698.0
(22) Date of filing: 24.11.2023
(51) Int. Cl.: G09F 9/30

(54) **FILM ASSEMBLY, DISPLAY SCREEN AND ELECTRONIC DEVICE**

(30) Priority: 02.12.2022 CN 202211537243
(71) Applicant: Huawei Technologies Co., Ltd., Shenzhen, Guangdong 518129 (CN)
(72) Inventor: LI, Weilin, Shenzhen, Guangdong 518129 (CN); WANG, Jie, Shenzhen, Guangdong 518129 (CN); LI, Min, Shenzhen, Guangdong 518129 (CN); ZHAO, Yaoxu, Shenzhen, Guangdong 518129 (CN)
(74) Representative: MERH-IP Matias Erny Reichl Hoffmann Patentanwälte PartG mbB
(86) International application number: PCT/CN2023/134163
(87) International publication number: WO 2024/114547

(57) **Abstract**

A film assembly, a display (12), and an electronic device (01) are provided, which relate to the field of optical devices, to resolve a problem of poor smoothness in opening and closing of the display. The display (12) includes a bending region (A), and the bending region (A) is configured to bend around a bending axis (001) when the display (12) is bent. The display (12) includes a film (100). The film (100) has a first elastic modulus (Ea) in a first direction (a), and the film (100) has a second elastic modulus (Eb) in a second direction (b). The first elastic modulus (Ea) is less than or equal to 3.5 GPa, and the second elastic modulus (Eb) is 1.5 times or more of the first elastic modulus (Ea). The first direction (a) is perpendicular to the second direction (b), and the first direction (a) is perpendicular to the bending axis (001). The display (12) further includes an adhesive layer (200) with a small energy storage modulus. When the display (12) is bent, the film (100) can ensure buffer performance of the bending region (A) and reduce a rebound force in the first direction (a). The adhesive layer (200) with low shear strain energy assists the film (100), so that the rebound force can be further reduced. **In** this way, the display (12) can hover at a specific opening/closing angle without an external force.

## Description

This application claims priority to Chinese Patent Application No. 202211537243.X, filed with the China National Intellectual Property Administration on December 2, 2022 and entitled "FILM ASSEMBLY, DISPLAY, AND ELECTRONIC DEVICE", which is incorporated herein by reference in its entirety.

### TECHNICAL FIELD

Embodiments of this application relate to the field of optical devices, and in particular, to a film assembly, a display, and an electronic device.

### BACKGROUND

With development of electronic devices in various fields, improving user convenience and experience becomes one of competition means of the electronic devices. For example, smoothness in opening and closing and free hovering become experience requirements of users for foldable electronic devices. With excellent smoothness in opening and closing, the foldable electronic device can be opened and closed comfortably. With free hovering, the foldable electronic device can hover at any opening/closing angle.

Currently, smooth opening and closing and free hovering are mainly implemented by using a hinge of the entire electronic device. However, costs and a weight of the foldable electronic device are increased due to the hinge.

Therefore, how to implement smooth opening and closing and free hovering of the foldable electronic device still needs to be resolved.

### SUMMARY

Embodiments of this application provide a film assembly, a display, and an electronic device, to effectively resolve problems, of poor smoothness in opening and closing and susceptibility to rebound during hovering, of a foldable device.

To achieve the foregoing objective, this application uses the following technical solutions. According to a first aspect, a display is provided. The display includes a bending region, and the bending region is configured to bend around a bending axis when the display is bent. The display includes a film, and a projection of the film on a surface of the display at least partially overlaps the bending region. The film has a first elastic modulus in a first direction, and the film has a second elastic modulus in a second direction. The first elastic modulus is less than or equal to 3.5 GPa, and the second elastic modulus is 1.5 times or more of the first elastic modulus. Both the first direction and the second direction are parallel to the surface of the display, the first direction is perpendicular to the second direction, and the first direction is perpendicular to the bending axis. In this case, when the display is bent, the film can store potential energy in the first direction, and reduce a rebound force of the bending region in the first direction, so that a trend of unfolding the display in a bending state is weakened. The second elastic modulus in the second direction is 1.5 times or more of the first elastic modulus, so that buffer performance of the bending region can be ensured, a case in which the display cannot be supported due to a small buffer in a bending process can be avoided, and a balanced state can be achieved. In this way, the display can be opened and closed smoothly and can freely hover.

With reference to the first aspect, in some implementations, the second elastic modulus is 1.7 times or more of the first elastic modulus. In this case, the film can better balance buffer performance of the bending region of the display and energy storage in the first direction, so that the display can be at a specific opening/closing angle for a long time without an external force.

With reference to the first aspect, in some implementations, a phase difference of the film is greater than or equal to 5000 nm. In this case, the film has a high light transmittance, no light scattering, large-area uniformity, and the like.

With reference to the first aspect, in some implementations, a thickness of the film ranges from 25 µm to 150 µm. In this case, the film has small impact on the thickness of the display, and can make an important contribution to free hovering of the display.

With reference to the first aspect, in some implementations, a material of the film includes at least one of polyester, polyimide, epoxy, polyaramid, polycarbonate, cellulose triacetate, polymethyl methacrylate, and cycloolefin polymer. In this case, a large quantity of materials are available for the film. This is conducive to controlling costs of the film.

With reference to the first aspect, in some implementations, the display further includes a light-emitting layer. The film is located on a light output side of the light-emitting layer, and a transmittance of the film is greater than or equal to 85%. In this case, impact of the film on light emitted by the light-emitting layer is small.

With reference to the first aspect, in some implementations, the display further includes an adhesive layer, and the adhesive layer is connected to at least one surface of the film. In this case, the film can be connected to other structures of the display through the adhesive layer.

With reference to the first aspect, in some implementations, an energy storage modulus of the adhesive layer meets the following conditions:
the energy storage modulus is less than or equal to 140 kPa at -20°C;
the energy storage modulus ranges from 10 kPa to 40 kPa at 25°C; and
the energy storage modulus is greater than or equal to 10 kPa at 60°C. In this case, shear strain energy of the adhesive layer is low, and a rebound force of the bending region after bending can be reduced. With assistance of the adhesive layer and the film, a free hovering capability can be further improved.

With reference to the first aspect, in some implementations, a material of the adhesive layer includes at least one of acrylic acid, silicone, and polyurethane. In this case, a large quantity of materials are available for the adhesive layer, so that cost increase caused by a shortage of some materials can be avoided.

With reference to the first aspect, in some implementations, the display includes a support assembly, a light-emitting assembly, a polarizer, and a cover assembly that are stacked. The film is disposed in at least one of a position between any adjacent two of the support assembly, the light-emitting assembly, the polarizer, and the cover assembly, a position in the support assembly, a position in the light-emitting assembly, a position in the cover assembly, and a position in the support assembly. In this case, during preparation of the display, the film can be formed at any position in a thickness direction of the display, and selection may be made based on process costs.

With reference to the first aspect, in some implementations, the display further includes a protection assembly, and the protection assembly is connected to a surface that is of the cover assembly and that is away from the polarizer. In this case, the protection assembly can prevent a scratch on the cover assembly during transportation or use.

With reference to the first aspect, in some implementations, the film is disposed in the protection assembly. In this case, the protection assembly enables the display to freely hover.

With reference to the first aspect, in some implementations, the display has a plurality of bending regions that are spaced apart. In this case, the display can be a multi-fold structure.

According to a second aspect, an electronic device is provided. The electronic device includes a housing and any display provided in the first aspect, and the housing is connected to the display. In this case, in a folding process, the electronic device including the display provided in the first aspect can be at a specific opening/closing angle for a long time, and opening and closing are smooth, to improve use experience of the display.

With reference to the second aspect, in some implementations, the electronic device is a foldable device. In this case, the display of the foldable device can freely hover in the folding process.

According to a third aspect, a support assembly is provided. The support assembly is used in a display. The display includes a bending region, and the bending region is configured to bend around a bending axis when the display is bent. The support assembly includes a film, and a projection of the film on a surface of the display at least partially overlaps the bending region. The film has a first elastic modulus in a first direction, and the film has a second elastic modulus in a second direction. The first elastic modulus is less than or equal to 3.5 GPa, and the second elastic modulus is 1.5 times or more of the first elastic modulus. Both the first direction and the second direction are parallel to the surface of the display, the first direction is perpendicular to the second direction, and the first direction is perpendicular to the bending axis. In this case, after the support assembly is used in the display, the display can be opened and closed smoothly and can freely hover in a bending process.

According to a fourth aspect, a film assembly is provided. The film assembly is configured to connect to a display. The film assembly includes a film and an adhesive layer located on at least one surface of the film. The film has a first elastic modulus in a first direction, and the film has a second elastic modulus in a second direction. The first elastic modulus is less than or equal to 3.5 GPa, and the second elastic modulus is 1.5 times or more of the first elastic modulus. The first direction is perpendicular to the second direction. An energy storage modulus of the adhesive layer meets the following conditions: the energy storage modulus is less than or equal to 140 kPa at -20°C; the energy storage modulus ranges from 10 kPa to 40 kPa at 25°C; and the energy storage modulus is greater than or equal to 10 kPa at 60°C. In this case, after the film assembly is used in the display, the display can be opened and closed smoothly and can freely hover in a bending process.

With reference to the fourth aspect, in some implementations, a transmittance of the adhesive layer is greater than or equal to 90%, and a transmittance of the film is greater than or equal to 85%. In this case, the film assembly has small impact on a transmittance of light, and has little impact on optical performance of the display.

### BRIEF DESCRIPTION OF DRAWINGS

FIG. 1a is an exploded diagram of a structure of an electronic device according to an embodiment of this application;
FIG. 1b is a diagram of a structure of an electronic device according to an embodiment of this application;
FIG. 1c is a diagram of a structure of another electronic device according to an embodiment of this application;
FIG. 1d is a diagram of a structure of a folding manner of the electronic device in FIG. 1c;
FIG. 1e is a diagram of a structure of another folding manner of the electronic device in FIG. 1c;
FIG. 2a is a diagram of a structure of a display according to an embodiment of this application;
FIG. 2b is a diagram of an internal structure of a display according to an embodiment of this application;
FIG. 2c is a diagram of a structure of a film and an adhesive layer according to an embodiment of this application;
FIG. 2d is a diagram of another structure of a film and an adhesive layer according to an embodiment of this application;
FIG. 2e is a diagram of a structure of a spliced film according to an embodiment of this application;
FIG. 3a is an exploded view of a display according to an embodiment of this application; and
FIG. 3b is a cross-sectional diagram of a display in a direction perpendicular to a surface of the display according to an embodiment of this application.

In the figure: 01: electronic device; 11: cover body; 12: display; 13: middle frame; 14: rear housing; 001: bending axis; 010: first end; 020: second end; 100: film; 110: light-emitting layer; 200: adhesive layer; 102: auxiliary film; 103: spliced film; 120: support assembly; 121: support member; 122: first adhesive layer; 123: first film layer; 124: second adhesive layer; 130: light-emitting assembly; 131: second film layer; 132: third adhesive layer; 140: polarizer; 150: cover assembly; 151: fourth adhesive layer; 152: third film layer; 160: protection assembly; 161: fifth adhesive layer; 162: fourth film layer.

### DESCRIPTION OF EMBODIMENTS

To make the objectives, technical solutions, and advantages of this application clearer, the following further describes this application in detail with reference to the accompanying drawings.

The terms "first", "second", and the like mentioned below are merely intended for a purpose of description, and shall not be understood as an indication or implication of relative importance or implicit indication of the quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

An embodiment of this application provides an electronic device. The electronic device may be a product having a display interface, such as a tablet computer, a mobile phone, an e-reader, a remote control, a personal computer (personal computer, PC), a notebook computer, a personal digital assistant (personal digital assistant, PDA), a vehicle-mounted device, a web television, a wearable device, or a television, or a smart display wearable product such as a smartwatch or a smart band. A form of the electronic device is not specifically limited in embodiments of this application.

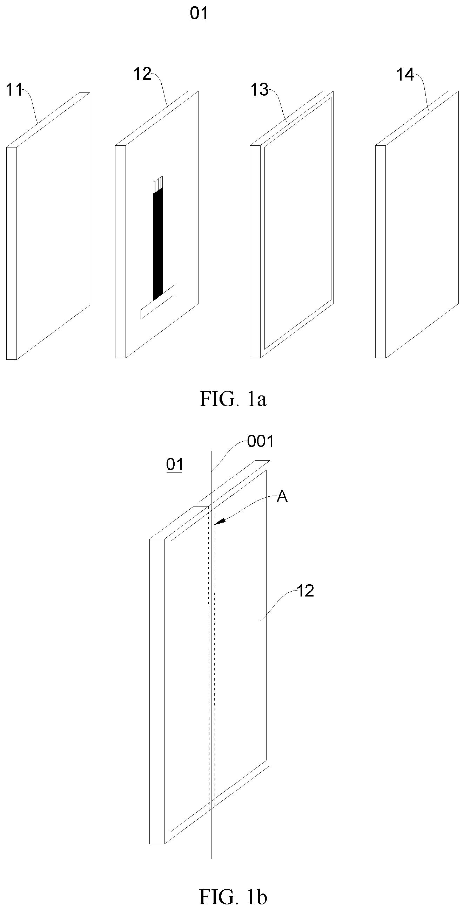

FIG. 1a is an exploded diagram of a structure of an electronic device 01 according to an embodiment of this application. As shown in FIG. 1a, the electronic device 01 includes a cover body 11, a display 12, a middle frame 13, and a rear housing 14. The rear housing 14 and the display 12 are respectively located on two sides of the middle frame 13. The middle frame 13 and the display 12 are disposed in the rear housing 14. The cover body 11 is disposed on a side that is of the display 12 and that is away from the middle frame 13. A display surface of the display 12 faces the cover body 11.

Structures of the display 12, the cover body 11, and the rear housing 14 are not limited in embodiments of this application, and may be set based on a purpose of the electronic device 01.

Electronic components such as a printed circuit board (printed circuit boards, PCB), a battery, and a camera in the electronic device 01 may be disposed on the middle frame 13.

In some embodiments of this application, the electronic device 01 may be a device with a foldable screen, including but not limited to a foldable mobile phone, a foldable tablet computer, or the like.

FIG. 1b is a diagram of a structure of an electronic device 01 according to an embodiment of this application. As shown in FIG. 1b, the electronic device 01 may rotate around a bending axis 001, so that the electronic device 01 is foldable.

A region enclosed by a dashed line in FIG. 1b is a region in which the display 12 is bent in a folding process of the electronic device 01. In this embodiment of this application, the region is defined as a bending region A. In the folding process of the electronic device 01, the bending region A bends around the bending axis 001.

It should be noted that, in embodiments of this application, the bending axis 001 does not actually exist, and is defined only for ease of description.

A folding direction of the electronic device 01 is not limited in embodiments of this application. For example, the electronic device 01 may be folded in a direction facing the display 12. Alternatively, the electronic device 01 may be folded in a direction away from the display 12, so that surfaces of the cover body 11 are folded toward each other.

In FIG. 1b, the electronic device 01 has a bending region A. The electronic device 01 is a two-fold structure.

A foldable structure of the electronic device 01 is not limited in embodiments of this application. For example, a hinge is disposed in the rear housing 14, and folding is implemented by using the hinge.

In another embodiment of this application, the electronic device 01 may have two, three, or more bending regions A, and the plurality of bending regions A are spaced apart. In this case, the electronic device 01 may be a multi-fold structure.

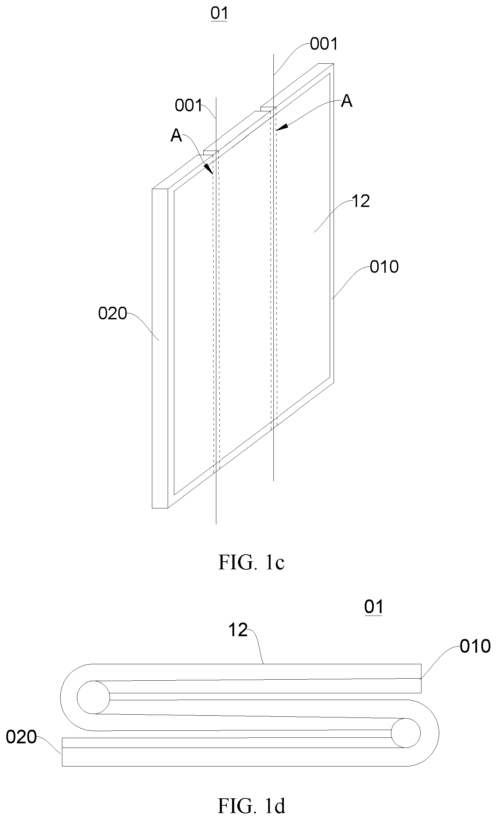

For example, FIG. 1c is a diagram of a structure of another electronic device 01 according to an embodiment of this application. As shown in FIG. 1c, the electronic device 01 has two bending regions A, and bending may be bent in each bending region A. In this case, the electronic device 01 is a triple-fold structure.

In the electronic device 01 having a plurality of bending axes 001, a folding manner of the electronic device 01 is not limited in embodiments of this application.

For example, in FIG. 1c, the electronic device 01 has a first end 010 and a second end 020 that are opposite to each other.

In some embodiments of this application, when the electronic device 01 is in a folded state, both the first end 010 and the second end 020 may be exposed on a surface.

In some other embodiments of this application, when the electronic device 01 is in the folded state, the first end 010 is located inside, and the second end 020 is exposed on the surface. Alternatively, when the electronic device 01 is in the folded state, the second end 020 is located inside, and the first end 010 is exposed on the surface.

FIG. 1d is a diagram of a structure of a folding manner of the electronic device 01 in FIG. 1c. In FIG. 1d, the electronic device 01 is in an S shape after being folded, and the first end 010 and the second end 020 are respectively located at two ends of the folded electronic device 01.

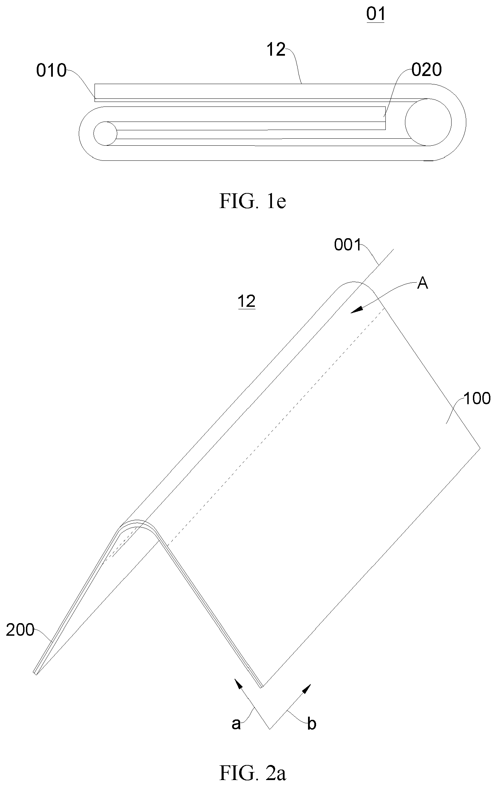

FIG. 1e is a diagram of a structure of another folding manner of the electronic device 01 in FIG. 1c. In FIG. 1e, the electronic device 01 is in a G shape after being folded. After folding, the second end 020 is accommodated in a middle part of the electronic device 01, and the first end 010 is located on one side of the folded electronic device 01.

In FIG. 1d and FIG. 1e, a maximum rotation angle of the electronic device 01 is approximate to 180°. It should be noted that the maximum rotation angle of the electronic device 01 is not limited in embodiments of this application. For example, the maximum rotation angle of the electronic device 01 may be less than 180°. For example, the maximum rotation angle of the electronic device 01 may be 5°, 10°, 20°, 30°, 40°, 50°, 70°, 80°, 90°, 110°, 120°, 130°, 150°, 160°, 180°, or the like.

In some scenarios in which the electronic device 01 is used, the electronic device 01 needs to be rotated to an angle that facilitates operation.

For example, for ease of reading or watching a video, the electronic device 01 needs to be at a specific opening/closing angle for a long time. A rebound force of the display 12 tends to make the electronic device 01 in an unstable state. As a result, the electronic device 01 cannot hover, for a long time, at an opening/closing angle expected by a user. This affects use. An embodiment of this application provides a display 12. A rebound force of the display 12 is small when the display 12 is in a bent state, so that a rebound force of an electronic device 01 can be reduced when the electronic device 01 is opened or closed at a specific angle. In this way, the electronic device 01 has advantages of smooth opening and closing and free hovering.

The display 12 may be used in a foldable electronic device 01.

It should be noted that a purpose of the display 12 is not limited in embodiments of this application. For example, the display 12 may be used in a non-foldable electronic device.

FIG. 2a is a diagram of a structure of a display 12 according to an embodiment of this application. Refer to FIG. 2a. The display 12 has a bending region A. When the display 12 is bent, the bending region A can bend around a bending axis 001.

The display 12 includes a film 100, and a projection of the film 100 on a surface of the display 12 at least partially overlaps the bending region A.

In other words, the projection of the film 100 on the surface of the display 12 completely overlaps the bending region A, or the projection of the film 100 on the surface of the display 12 partially overlaps the bending region A.

In an embodiment in which the projection of the film 100 on the surface of the display 12 partially overlaps the bending region A, the projection of the film 100 on the surface of the display 12 may be located only inside the bending region A. That is, the projection of the film 100 on the surface of the display 12 is completely located inside the bending region A. Alternatively, the projection of the film 100 on the surface of the display 12 is partially located inside the bending region A, and is partially located outside the bending region A.

The projection of the film 100 on the surface of the display 12 is a projection of the film 100 in a direction perpendicular to a light-emitting surface of the display 12, that is, a projection of the film 100 in a thickness direction of the display 12.

In this embodiment of this application, an elastic modulus of the film 100 is anisotropic. The film 100 has a first elastic modulus Ea in a first direction a, the film 100 has a second elastic modulus Eb in a second direction b, the first elastic modulus Ea is less than or equal to 3.5 GPa, and the second elastic modulus Eb is 1.5 times or more of the first elastic modulus Ea.

Both the first direction a and the second direction b are parallel to the surface of the display 12, the first direction a is perpendicular to the second direction b, and the first direction a is perpendicular to the bending axis 001.

In this case, in a process in which the bending region A of the display 12 bends around the bending axis 001, the first elastic modulus Ea of the film 100 is small, and the film 100 may store energy in the first direction a, to reduce a rebound force formed in the first direction a due to bending, and achieve a purpose of smooth opening and closing and free hovering. In addition, the second elastic modulus Eb in the second direction b is large, to ensure excellent buffer performance of the film 100 in a bending process of the display 12.

In this embodiment of this application, a method for measuring the elastic modulus (elastic modulus or modulus of elasticity) may be, for example, as follows:
A sample with a size of 100 mm*10 mm is tested by using a universal testing machine, where a fixture spacing is 50 mm, and the sample is stretched at a speed of 5 mm/min to obtain a stress-strain curve. A Young's modulus (Young's modulus) corresponding to the sample is calculated. A modulus calculation region ranges from 0.2% to 0.5%.

In this embodiment of this application, an included angle between the first direction a and the second direction b is not limited to 90°. For example, the included angle between the first direction a and the second direction b ranges from 70° to 110°, for example, may be 70°, 72°, 75°, 78°, 80°, 83°, 85°, 86°, 87°, 88°, 89°, 90°, 92°, 95°, 98°, 100°, 104°, 106°, 108°, 110°, or the like.

Similarly, an included angle between the first direction a and the bending axis 001 is not limited to 90°. For example, the included angle between the first direction a and the bending axis 001 ranges from 70° to 90°, for example, may be 70°, 72°, 75°, 78°, 80°, 83°, 85°, 86°, 87°, 88°, 89°, 90°, or the like.

For example, the first elastic modulus Ea may be 0.5 GPa, 0.8 GPa, 1 GPa, 1.3 GPa, 1.5 GPa, 1.8 GPa, 2 GPa, 2.2 GPa, 2.4 GPa, 2.7 GPa, 3 GPa, 3.2 GPa, 3.5 GPa, or the like.

For example, the second elastic modulus Eb is 1.5 times, 1.6 times, 1.7 times, 1.8 times, 1.9 times, 2 times, 2.2 times, 2.5 times, 3 times, 3.5 times, or the like of the first elastic modulus Ea. In some embodiments, the second elastic modulus Eb is 1.7 times or more of the first elastic modulus Ea. In this case, the film 100 has excellent buffer performance, and can absorb elastic potential energy generated when the display 12 is bent, so that the display 12 can be stable at each opening/closing angle for a long time.

A thickness of the film 100 is not limited in embodiments of this application. For example, the thickness of the film 100 ranges from 25 µm to 150 µm. For example, the thickness of the film 100 is 25 µm, 30 µm, 35 µm, 40 µm, 45 µm, 50 µm, 55 µm, 60 µm, 70 µm, 80 µm, 90 µm, 100 µm, 120 µm, 130 µm, 140 µm, 150 µm, or the like. In this case, the film 100 can store a large amount of energy in the first direction a, to reduce the rebound force in the first direction a, and reduce a rebound force, of the bending region A, existing after the display 12 hovers.

A material of the film 100 is not limited in embodiments of this application. For example, the material of the film 100 includes at least one of polyester, polyimide, epoxy, polyaramid, polycarbonate, cellulose triacetate, polymethyl methacrylate, and cycloolefin polymer. The material of the film 100 may be selected from a plurality of materials. This helps reduce manufacturing costs of the film 100.

A phase difference of the film 100 is not limited in embodiments of this application. For example, the phase difference of the film 100 is greater than or equal to 5000 nm, so that the film 100 has advantages such as a high light transmittance, no light scattering, and large-area uniformity. For example, the phase difference of the film 100 is 5000 nm, 6000 nm, 7000 nm, 8000 nm, 10000 nm, 12000 nm, or the like.

A position relationship between the film 100 and the display 12 is not limited in embodiments of this application. For example, the film 100 may be located on the surface of the display 12, or may be located inside the display 12.

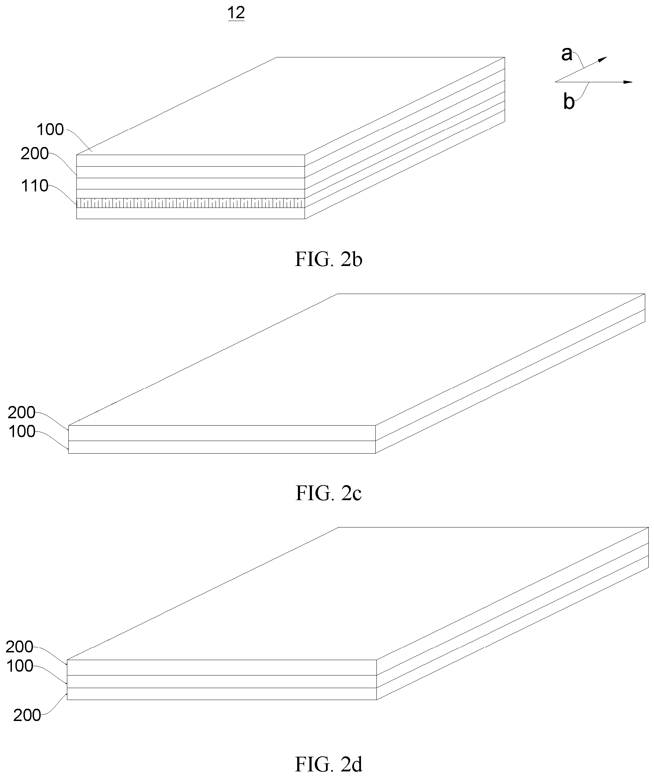

FIG. 2b is a diagram of an internal structure of a display 12 according to an embodiment of this application. Refer to FIG. 2b. The display 12 further includes a light-emitting layer 110. The light-emitting layer 110 and the film 100 are stacked.

In some embodiments, the film 100 is located on a light output side of the light-emitting layer 110. In some other embodiments, the film 100 is located on a backlight side of the light-emitting layer 110.

In the embodiment in which the film 100 is located on the light output side of the light-emitting layer 110, a transmittance of the film 100 is greater than or equal to 85%. For example, the transmittance of the film 100 is 85%, 87%, 90%, 92%, 95%, 97%, or the like. In this case, impact of the film 100 on light emitted by the light-emitting layer 110 is small.

In the embodiment in which the film 100 is located on the backlight side of the light-emitting layer 110, the transmittance of the film 100 is not limited, and may be set based on a use requirement of the display 12.

Still refer to FIG. 2b. In some embodiments of this application, the display 12 further includes an adhesive layer 200. The adhesive layer 200 is connected to the film 100.

A position relationship between the adhesive layer 200 and the film 100 is not limited in embodiments of this application. For example, the adhesive layer 200 may be connected to one surface of the film 100. Alternatively, the adhesive layer 200 may be connected to two surfaces of the film 100.

FIG. 2c is a diagram of a structure of a film 100 and an adhesive layer 200 according to an embodiment of this application. In FIG. 2c, one surface of the film 100 is connected to the adhesive layer 200.

FIG. 2d is a diagram of another structure of a film 100 and an adhesive layer 200 according to an embodiment of this application. In FIG. 2d, both surfaces of the film 100 are connected to the adhesive layer 200. In this case, both surfaces of the film 100 can be connected to another component in the display 12 through the adhesive layer 200.

In FIG. 2c and FIG. 2d, the adhesive layer 200 is directly connected to the film 100.

In another embodiment of this application, the adhesive layer 200 is indirectly connected to the film 100. In other words, there may be another structure of the display 12 between the adhesive layer 200 and the film 100. For example, there may be a filling material between the adhesive layer 200 and the film 100. Alternatively, the adhesive layer 200 and the film 100 may be respectively located on the light output side and the backlight side of the light-emitting layer 110.

A thickness of the adhesive layer 200 is not limited in embodiments of this application. For example, the thickness of the adhesive layer 200 ranges from 15 µm to 100 µm. For example, the thickness of the adhesive layer 200 is 15 µm, 20 µm, 30 µm, 40 µm, 50 µm, 60 µm, 70 µm, 80 µm, 90 µm, 100 µm, or the like. A better bonding capability of the adhesive layer 200 can be implemented within the foregoing thickness range.

A material of the adhesive layer 200 is not limited in embodiments of this application. For example, the material of the adhesive layer 200 includes at least one of acrylic acid, silicone, and polyurethane. A large quantity of materials are available for the adhesive layer 200, so that cost increase caused by a shortage of some materials can be avoided.

In some embodiments of this application, the material of the adhesive layer 200 is a photosensitive adhesive. The photosensitive adhesive has excellent bonding effect, low-temperature resistance, high-temperature resistance, high-humidity resistance, and other properties.

In some embodiments of this application, an energy storage modulus of the adhesive layer 200 meets the following conditions:
the energy storage modulus is less than or equal to 140 kPa at -20°C; the energy storage modulus ranges from 10 kPa to 40 kPa at 25°C; and the energy storage modulus is greater than or equal to 10 kPa at 60°C. In this case, shear strain energy of the adhesive layer 200 is low, and a rebound force of the bending region A after bending can be reduced. With assistance of the adhesive layer 200 and the film 100, a free hovering capability can be further improved.

For example, the energy storage modulus of the adhesive layer 200 at -20°C may be, for example, 140 kPa, 130 kPa, 120 kPa, 110 kPa, 100 kPa, 90 kPa, 80 kPa, 60 kPa, or the like.

For example, the energy storage modulus of the adhesive layer 200 at 25°C may be, for example, 10 kPa, 15 kPa, 20 kPa, 30 kPa, 35 kPa, 40 kPa, or the like.

For example, the energy storage modulus of the adhesive layer 200 at 60°C may be, for example, 10 kPa, 12 kPa, 16 kPa, 18 kPa, 22 kPa, 25 kPa, 30 kPa, 35 kPa, 40 kPa, 50 kPa, or the like.

In this embodiment of this application, the energy storage modulus of the adhesive layer 200 may be tested in the following method.

A circular disc of the adhesive layer with a thickness of 0.5 mm and a diameter of 8 mm is tested by using a rotational rheometer. Conditions of the rotational rheometer are set as follows: (1) temperature: -50°C to 100°C, with a temperature rise speed of 1°C/min; (2) strain: 1%; (3) frequency: 1 Hz; and (4) pressure in a Z direction: 0.1 N. After a test is completed, the energy storage modulus of the adhesive layer at a corresponding temperature is recorded.

A position relationship between the adhesive layer 200 and another structure of the display 12 is not limited in embodiments of this application.

For example, in an embodiment in which the adhesive layer 200 is located on the light output side of the light-emitting layer 110, a transmittance of the adhesive layer 200 is greater than or equal to 90%. For example, the transmittance of the adhesive layer 200 is 90%, 91%, 92%, 95%, 96%, 97%, or the like. In this case, impact of the adhesive layer 200 on light emitted by the light-emitting layer 110 is small.

In the embodiment in which the adhesive layer 200 is located on the light output side of the light-emitting layer 110, a phase difference of the adhesive layer 200 is greater than or equal to 5000 nm, so that the adhesive layer 200 has a high light transmittance, no light scattering, large-area uniformity, and the like. For example, the phase difference of the adhesive layer 200 is 5000 nm, 6000 nm, 7000 nm, 8000 nm, 9000 nm, 11000 nm, or the like.

In an embodiment in which the adhesive layer 200 is located on the backlight side of the light-emitting layer 110, the transmittance of the adhesive layer 200 is not limited.

In the embodiment in which the adhesive layer 200 is located on the backlight side of the light-emitting layer 110, the phase difference of the adhesive layer 200 is not limited.

In FIG. 2a, a size of the film 100 is the same as that of the display 12. In other words, the display 12 has the film 100 that meets the foregoing conditions and that has the same size as the display 12.

In some embodiments of this application, the size of the film 100 may be less than that of the display 12.

In the embodiment in which the size of the film 100 is less than that of the display 12, the film 100 and another film may be spliced into a spliced film whose size is the same as that of the display 12. An elastic modulus of the another film is not limited in embodiments of this application.

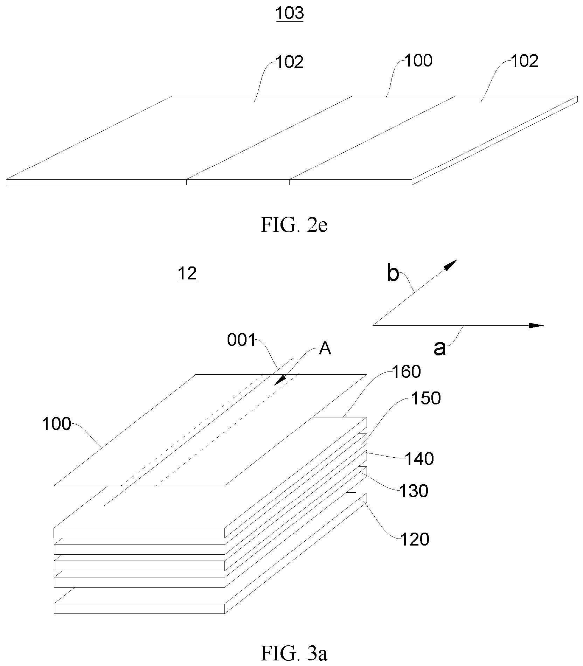

FIG. 2e is a diagram of a structure of a spliced film 103 according to an embodiment of this application. The spliced film 103 has a same size as a display. The spliced film 103 includes a film 100 and an auxiliary film 102. The film 100 and the auxiliary film 102 are coplanar. The film 100 and the auxiliary film 102 are spliced.

After the spliced film 103 is connected to other structures of the display 12, a projection of the film 100 on a surface of the display 12 at least partially overlaps a bending region A.

In an embodiment in which the projection of the film 100 on the surface of the display 12 partially overlaps with the bending region A, a part of a projection of the auxiliary film 102 on the surface of the display 12 may be located inside the bending region A.

It may be understood that the part of the projection of the auxiliary film 102 on the surface of the display 12 may alternatively not be located inside the bending region A. For example, the projection of the film 100 on the surface of the display 12 covers the entire bending region A, and the projection of the auxiliary film 102 on the surface of the display 12 is located outside the bending region A.

An elastic modulus and the like of the auxiliary film 102 are not limited in embodiments of this application. For example, the elastic modulus of the auxiliary film 102 is isotropic. Alternatively, the elastic modulus of the auxiliary film 102 is anisotropic, and a magnitude of a modulus in each direction is not limited.

In this embodiment of this application, performance of regions of the auxiliary film 102 may not be completely the same. For example, the auxiliary film 102 includes a first region, a second region, and a third region. An elastic modulus of the first region, an elastic modulus of the second region, and an elastic modulus of the third region may not be completely the same. This is not limited in embodiments of this application.

Shapes of the film 100 and the auxiliary film 102 are not limited in embodiments of this application. The film 100 and the auxiliary film 102 may be in a shape of a square, a circle, or the like, or may be in a shape of an irregular sawtooth or the like.

Similarly, the adhesive layer 200 is connected to a surface of the film 100. In the embodiment in which the size of the film 100 is less than that of the display 12, a surface of the auxiliary film 102 is connected to an adhesive-film layer structure.

Performance of the adhesive-film layer structure connected to the surface of the auxiliary film 102 is not limited in embodiments of this application. For example, the adhesive-film layer structure connected to the surface of the auxiliary film 102 may be the adhesive layer 200 that meets the foregoing energy storage modulus conditions, or the adhesive-film layer structure connected to the surface of the auxiliary film 102 may not meet the foregoing energy storage modulus conditions.

This is similar for a relationship between the adhesive layer 200 and the adhesive-film layer structure and a relationship between the film 100 and the auxiliary film 102. Details are not described herein again.

FIG. 3a is an exploded view of a display 12 according to an embodiment of this application. Refer to FIG. 3a. The display 12 further includes a support assembly 120, a light-emitting assembly 130, a polarizer 140, and a cover assembly 150 that are stacked.

A position of the film 100 in the display 12 is not limited in embodiments of this application. For example, the film 100 is disposed in at least one position of a position between any adjacent two of the support assembly 120, the light-emitting assembly 130, the polarizer 140, and the cover assembly 150, a position in the support assembly 120, a position in the light-emitting assembly 130, and a position in the cover assembly 150.

The foregoing "in the support assembly 120" indicates a non-surface position of the support assembly 120, and this is similar for "in the light-emitting assembly 130" and "in the cover assembly 150". Details are not described herein again.

In this case, during preparation of the display 12, the film 100 can be formed at any position in the thickness direction of the display 12, and selection may be made based on process costs.

The foregoing at least one position means that the film 100 may be disposed at only one position, or may be disposed at two, three, or more positions.

A quantity of layers of the film 100 in the display 12 is not limited in embodiments of this application. At any one of the foregoing positions, there may be one layer, two layers, or a plurality of layers of films 100.

In an embodiment in which there are a plurality of layers of films 100 in the display 12, shapes of the plurality of layers of films 100 may be the same or may not be completely the same.

In some embodiments of this application, the display 12 further includes a protection assembly 160, and the protection assembly 160 is connected to a surface that is of the cover assembly 150 and that is away from the polarizer 140. In this case, the protection assembly 160 can prevent a scratch on the cover assembly 150 during transportation or use.

In some embodiments, the protection assembly 160 includes the film 100. In this case, the protection assembly 160 enables the display 12 to freely hover.

In some embodiments of this application, the film 100 may be disposed only in the protection assembly 160.

In this embodiment of this application, the protection assembly 160 is not necessary, and the protection assembly 160 may not be disposed. Alternatively, the protection assembly 160 may be connected to the cover assembly 150 when the display 12 is used. In this case, in a process of producing the display 12, the protection assembly 160 may not be produced.

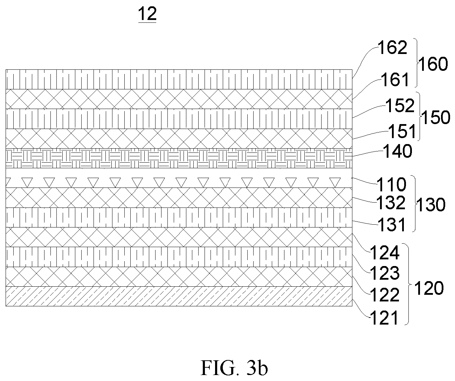

Structures of the support assembly 120, the light-emitting assembly 130, and the cover assembly 150 are not limited in embodiments of this application. The following describes the support assembly 120, the light-emitting assembly 130, and the cover assembly 150 in some embodiments of this application as examples with reference to FIG. 3b.

FIG. 3b is a cross-sectional diagram of a display 12 in a direction perpendicular to a surface of the display 12 according to an embodiment of this application.

Refer to FIG. 3b. The support assembly 120 includes a support member 121, a first adhesive layer 122, a first film layer 123, and a second adhesive layer 124 that are sequentially stacked.

The light-emitting assembly 130 includes a second film layer 131, a third adhesive layer 132, and the light-emitting layer 110 that are sequentially stacked. The second film layer 131 is connected to a surface that is of the second adhesive layer 124 and that is away from the first film layer 123.

The polarizer 140 is connected to a surface that is of the light-emitting layer 110 and that is away from the third adhesive layer 132.

The cover assembly 150 includes a fourth adhesive layer 151 and the third film layer 152 that are sequentially stacked. The fourth adhesive layer 151 is connected to a surface that is of the polarizer 140 and that is away from the light-emitting layer 110.

The protection assembly 160 includes a fifth adhesive layer 161 and a fourth film layer 162 that are sequentially stacked. The fifth adhesive layer 161 and the third film layer 152 are connected in a stacked manner.

In this embodiment of this application, at least one of the first film layer 123, the second film layer 131, the third film layer 152, and the fourth film layer 162 includes the film 100. Further, there may be one or more layers of films 100. In this case, there are a plurality of positions for disposition of the film 100, allowing for a wide range of options.

In this embodiment of this application, an elastic modulus of another film layer that is among the first film layer 123, the second film layer 131, the third film layer 152, and the fourth film layer 162 and that is not the film 100 is limited.

For example, the elastic modulus of the another film layer may be isotropic, and an elastic modulus of the elastic modulus may range from 4 GPa to 8 GPa. For example, the elastic modulus of the another film layer may be 4 GPa, 5 GPa, 6 GPa, 7 GPa, 8 GPa, or the like.

A material of the another film layer is also not limited, for example, may be polyethylene terephthalate (polyethylene terephthalate, PET), polyimide (Polyimide, PI), or the like. The second film layer 131 includes the film 100. This helps further reduce the rebound force of the bending region A after bending. In addition, the fourth film layer 162 includes the film 100. This also helps further reduce the rebound force of the bending region A after bending.

In this embodiment of this application, in an embodiment in which the first film layer 123 includes the film 100, the first film layer 123 may further include another film structure, for example, may include the foregoing spliced film 103.

According to the foregoing descriptions, in the embodiment in which the film 100 is located on the light output side of the light-emitting layer 110, the transmittance of the film 100 is greater than or equal to 85%. In this case, in an embodiment in which the third film layer 152 or the fourth film layer 162 includes the film 100, the transmittance of the film 100 is greater than or equal to 85%.

The structure of the support assembly 120 is not limited in embodiments of this application, and is not limited to the structure shown in FIG. 3b. For example, the support assembly 120 may further include a structure such as a buffer layer. Similarly, the light-emitting assembly 130, the cover assembly 150, and the protection assembly 160 are not limited either.

In some embodiments of this application, the surface of the display 12 further includes a coating, and the coating is located on a surface that is of the protection assembly 160 and that is away from the cover assembly 150. The coating may be at least one of an anti-fingerprint (anti-fingerprint, AF) coating, an anti-reflection (anti-reflection, AR) coating, an anti-glare (anti-glare, AG) coating, or an anti-scratch hard coating (hard coating, HC).

In some embodiments, the foregoing coating may also be disposed on a surface that is of the cover assembly 150 and that is away from the polarizer 140. Details are not described herein again.

Similarly, at least one of the first adhesive layer 122, the second adhesive layer 124, the third adhesive layer 132, the fourth adhesive layer 151, and the fifth adhesive layer 161 includes the adhesive layer 200, and there may be one or more adhesive layers 200. For other descriptions, refer to the foregoing descriptions of the film 100. Details are not described herein again.

In this embodiment of this application, no limitation is imposed on another adhesive layer that is among the first adhesive layer 122, the second adhesive layer 124, the third adhesive layer 132, the fourth adhesive layer 151, and the fifth adhesive layer 161 and that is not the adhesive layer 200.

For example, an energy storage modulus of the another adhesive layer at 25°C may range from 20 kPa to 50 kPa, for example, may be 20 kPa, 30 kPa, 35 kPa, 40 kPa, or 50 kPa.

It should be noted that a position of the adhesive layer 200 is not related to a position of the film 100, and both the adhesive layer 200 and the film 100 may be disposed as required.

In this embodiment of this application, performance of the adhesive layer 200, a position of the adhesive layer 200 in the display 12, performance of the film 100, and the position of the film 100 in the display 12 are used as variables for experiments. Specific experiments and experimental results are as follows.

### Experiment group L

An experiment is conducted by using the first elastic modulus Ea and the second elastic modulus Eb of the film 100, the included angle between the first direction a and the bending axis 001, and the included angle between the second direction b and the bending axis 001 as variables. Table 1 lists experimental results.

In the experiment group L, the thickness of the film 100 is 50 µm, and the film 100 is located at a position of the fourth film layer 162 in FIG. 3b. Other film layers are polyimide whose elastic modulus is isotropic, and the elastic modulus of polyimide is 5 GPa.

PET (Polyethylene terephthalate) in Table 1 is polyethylene terephthalate. PI (Polyimide) is polyimide.

A rebound force in Table 1 is a reaction force measured at a bending position when the display is folded by 180°, and a test temperature of the rebound force is 25°C.

In Table 1, bending at a room temperature means observing appearance of the display at 25°C, and being qualified means that the appearance of the display is uniform and has no bubbles and no delamination.

In Table 1, bending at high room temperature means observing the appearance of the display at 60°C, and being qualified means that the appearance of the display is uniform and has no bubbles and no delamination.

In Table 1, bending at a low temperature means observing appearance of the display at -25°C, and being qualified means that the appearance of the display is uniform and has no bubbles and no delamination. Falling off means separation of the film from an adjacent layer structure.

**Table 1**

| Experiment group | First elastic modulus Ea (GPa) | Included angle (°) between a first direction and a bending axis | Second elastic modulus Eb (GPa) | Included angle (°) between a second direction and the bending axis | Film material | Rebound force (kgf/c m) | Bending at a room temperature | Bending at a high temperature | Bending at a low temperature |
|---|---|---|---|---|---|---|---|---|---|
| L1 | 3.5 | 45 | 6.5 | 45 | PET | 2.22 | Qualified | Qualified | Qualified |
| L2 | 3.5 | 60 | 6.5 | 30 | PET | 2.23 | Qualified | Qualified | Qualified |
| L3 | 3.5 | 75 | 6.5 | 15 | PET | 2.14 | Qualified | Qualified | Qualified |
| L4 | 3.5 | 80 | 6.5 | 10 | PET | 2.12 | Qualified | Qualified | Qualified |
| L5 | 3.5 | 85 | 6.5 | 5 | PET | 2.06 | Qualified | Qualified | Qualified |
| L6 | 3.5 | 90 | 6.5 | 0 | PET | 2.00 | Qualified | Qualified | Qualified |
| L7 | 6.5 | 90 | 3.5 | 0 | PET | 2.24 | Qualified | Qualified | Falling off |
| L8 | 4.8 | 90 | 6.1 | 0 | PET | 2.13 | Qualified | Qualified | Falling off |
| L9 | 6.1 | 90 | 4.8 | 0 | PET | 2.22 | Qualified | Qualified | Falling off |
| L10 | 2.7 | 90 | 7.5 | 0 | PET | 1.92 | Qualified | Qualified | Qualified |
| L11 | 7.5 | 90 | 2.7 | 0 | PET | 2.30 | Qualified | Qualified | Falling off |
| L12 | 7.6 | 90 | 7.6 | 0 | PI | 2.31 | Qualified | Qualified | Falling off |
| L13 | 6.5 | 90 | 6.5 | 0 | PI | 2.25 | Qualified | Qualified | Falling off |

It can be learned from Table 1 that, when other conditions are the same and the included angle between the first direction and the bending axis is 90°, a ratio of the second elastic modulus Eb to the first elastic modulus Ea is greater than or equal to 1.85, a rebound force of a screen module is the smallest, and bending at the high temperature, the room temperature, and the low temperature is all qualified. When the second elastic modulus Eb and the first elastic modulus Ea are small, a falling-off risk exists during bending at the low temperature.

### Experiment group M

A single-factor variable experiment is conducted with a position of the film 100 at the first film layer 123, the second film layer 131, the third film layer 152, or the fourth film layer 162 in FIG. 3b. Film layers at other positions are polyimide whose elastic modulus is isotropic, and the elastic modulus of the polyimide is 5 GPa. Table 2 lists experimental results.

In Table 2, a position ① represents that the film 100 at a position of the fourth film layer 162. A position ② represents that the film 100 at a position of the third film layer 152. A position ③ represents that the film 100 at a position of the second film layer 131. A position ④ represents that the film 100 at a position of the first film layer 123. For other indicators in Table 2, refer to descriptions in Table 1. Details are not described herein again.

**Table 2**

| Embodiment | First elastic modulus Ea (GPa) | Included angle (°) between a first direction and a bending axis | Second elastic modulus Eb (GPa) | Included angle (°) between a second direction and the bending axis | Thickness (µm) | Film material | Use position | Rebound force (kgf/cm) |
|---|---|---|---|---|---|---|---|---|
| M1 | 3.5 | 90 | 6.5 | 0 | 50 | PET | ① | 2.00 |
| M2 | 3.5 | 90 | 6.5 | 0 | 50 | PET | ② | 2.26 |
| M3 | 3.5 | 90 | 6.5 | 0 | 50 | PET | ③ | 2.08 |
| M4 | 3.5 | 90 | 6.5 | 0 | 50 | PET | ④ | 2.15 |
| M5 | 2.7 | 90 | 7.5 | 0 | 50 | PET | ① | 1.92 |
| M6 | 2.7 | 90 | 7.5 | 0 | 50 | PET | ② | 2.25 |
| M7 | 2.7 | 90 | 7.5 | 0 | 50 | PET | ③ | 2.07 |
| M8 | 2.7 | 90 | 7.5 | 0 | 50 | PET | ④ | 2.13 |

It can be learned from Table 2 that, when other factors are the same, compared with embodiments in which the film 100 is at the position of the second film layer 131 and the position of the fourth film layer 162, in embodiments in which the film 100 is at the position of the third film layer 152 and the position of the first film layer 123, a rebound force of the display 12 after bending is smaller, which is conducive to free hovering of the display 13 after bending.

### Experiment group N

A single-factor variable experiment is conducted by using an energy storage modulus of the adhesive layer as a variable. The first adhesive layer 122, the second adhesive layer 124, the third adhesive layer 132, the fourth adhesive layer 151, and the fifth adhesive layer 161 all adhesive layers whose energy storage modulus meets conditions in Table 3. The film 100 is at the position of the fourth film layer 162, and the thickness of the film 100 is 50 µm. Table 3 lists experimental results.

**Table 3**

| | Film | | | | | | Adhesive layer | | | Display |
|---|---|---|---|---|---|---|---|---|---|---|
| Embodiment | First elastic modulus Ea (GPa) | Included angle (°) between a first direction and a bending axis | Second elastic modulus Eb (GPa) | Included angle between a second direction and the bending axis | Thickness (µm) | Use position | Energy storage modulus (kPa) | | | Rebound force (kgf/cm) |
| | | | | | | | -20°C | 25°C | 60°C | |
| N1 | 2.7 | 90 | 7.5 | 0 | 50 | ① | 240 | 36 | 23 | 2.00 |
| N2 | 2.7 | 90 | 7.5 | 0 | 50 | ① | 140 | 27 | 16 | 1.75 |
| N3 | 2.7 | 90 | 7.5 | 0 | 50 | ① | 120 | 45 | 23 | 2.09 |
| N4 | 2.7 | 90 | 7.5 | 0 | 50 | ① | 1334 | 84 | 50 | 2.46 |
| N5 | 2.7 | 90 | 7.5 | 0 | 50 | ① | 8900 | 150 | 35 | 2.96 |

It can be learned from Table 3 that, when other factors are the same, a rebound force of a bent display that includes an adhesive layer with a low energy storage modulus is lower, which is conducive to free hovering of the display after the display is folded.

The display 12 provided in this embodiment of this application includes the film 100. When the display 12 is bent around the bending axis 001, the film 100 may store the elastic modulus in the first direction a, to reduce the rebound force of the bending region A in the first direction a. A small rebound force reduces a probability that the display 12 rebounds, so that the display 12 has advantages of free hovering and smooth opening and closing. In addition, the second elastic modulus Eb of the film 100 in the second direction b is large, to ensure excellent buffer performance in the bending region A.

Clearly, a display module including the display 12 may freely hover at a specific angle. The display module may include the display 12 and a flexible circuit board. The flexible circuit board is electrically connected to the display 12.

Correspondingly, in a folding process, the electronic device 01 including the display 12 can be at a specific opening/closing angle for a long time, and opening and closing are smooth, to improve use experience of the display 12.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display, wherein the display comprises a bending region, and the bending region is configured to bend around a bending axis when the display is bent;
the display comprises a film, and a projection of the film on a surface of the display at least partially overlaps the bending region;
the film has a first elastic modulus in a first direction, the film has a second elastic modulus in a second direction, the first elastic modulus is less than or equal to 3.5 GPa, and the second elastic modulus is 1.5 times or more of the first elastic modulus; and
both the first direction and the second direction are parallel to the surface of the display, the first direction is perpendicular to the second direction, and the first direction is perpendicular to the bending axis.

2. The display according to claim 1, wherein the second elastic modulus is 1.7 times or more of the first elastic modulus.

3. The display according to claim 1 or 2, wherein
a phase difference of the film is greater than or equal to 5000 nm.

4. The display according to any one of claims 1 to 3, wherein
a thickness of the film ranges from 25 µm to 150 µm.

5. The display according to any one of claims 1 to 4, wherein
a material of the film comprises at least one of polyester, polyimide, epoxy, polyaramid, polycarbonate, cellulose triacetate, polymethyl methacrylate, and cycloolefin polymer.

6. The display according to any one of claims 1 to 5, wherein the display further comprises a light-emitting layer, the film is located on a light output side of the light-emitting layer, and a transmittance of the film is greater than or equal to 85%.

7. The display according to any one of claims 1 to 6, wherein the display further comprises an adhesive layer, and the adhesive layer is connected to at least one surface of the film.

8. The display according to claim 7, wherein an energy storage modulus of the adhesive layer meets the following conditions:
the energy storage modulus is less than or equal to 140 kPa at -20°C;
the energy storage modulus ranges from 10 kPa to 40 kPa at 25°C; and
the energy storage modulus is greater than or equal to 10 kPa at 60°C.

9. The display according to claim 7 or 8, wherein
a material of the adhesive layer comprises at least one of acrylic acid, silicone, and polyurethane.

10. The display according to any one of claims 1 to 9, wherein the display comprises a support assembly, a light-emitting assembly, a polarizer, and a cover assembly that are stacked, and the film is disposed in at least one of a position between any adjacent two of the support assembly, the light-emitting assembly, the polarizer, and the cover assembly, a position in the support assembly, a position in the light-emitting assembly, a position in the cover assembly, and a position in the support assembly.

11. The display according to claim 10, wherein the display further comprises a protection assembly, and the protection assembly is connected to a surface that is of the cover assembly and that is away from the polarizer.

12. The display according to claim 11, wherein the film is disposed in the protection assembly.

13. The display according to any one of claims 1 to 12, wherein the display has a plurality of bending regions that are spaced apart.

14. An electronic device, wherein the electronic device comprises a housing and the display according to any one of claims 1 to 13, and the housing is connected to the display.

15. The electronic device according to claim 14, wherein the electronic device is a foldable device.

16. A support assembly, wherein the support assembly is used in a display, the display comprises a bending region, and the bending region is configured to bend around a bending axis when the display is bent;
the support assembly comprises a film, and a projection of the film on a surface of the display at least partially overlaps the bending region;
the film has a first elastic modulus in a first direction, the film has a second elastic modulus in a second direction, the first elastic modulus is less than or equal to 3.5 GPa, and the second elastic modulus is 1.5 times or more of the first elastic modulus; and
both the first direction and the second direction are parallel to the surface of the display, the first direction is perpendicular to the second direction, and the first direction is perpendicular to the bending axis.

17. A film assembly, wherein the film assembly is configured to connect to a display; and
the film assembly comprises a film and an adhesive layer located on at least one surface of the film, wherein
the film has a first elastic modulus in a first direction, the film has a second elastic modulus in a second direction, the first elastic modulus is less than or equal to 3.5 GPa, the second elastic modulus is 1.5 times or more of the first elastic modulus, and the first direction is perpendicular to the second direction; and
an energy storage modulus of the adhesive layer meets the following conditions:
the energy storage modulus is less than or equal to 140 kPa at -20°C;
the energy storage modulus ranges from 10 kPa to 40 kPa at 25°C; and
the energy storage modulus is greater than or equal to 10 kPa at 60°C.

18. The film assembly according to claim 17, wherein a transmittance of the adhesive layer is greater than or equal to 90%, and a transmittance of the film is greater than or equal to 85%.
